# EUROPEAN PATENT APPLICATION

(11) **EP 4 421 847 A1**
(43) Date of publication of application: **28.08.2024**
(21) Application number: 23158358.4
(22) Date of filing: 23.02.2023
(51) Int. Cl.: H01L 21/02

(54) **METHOD OF FABRICATING A GROUP III NITRIDE LAYER ON A SUBSTRATE**

(71) Applicant: Infineon Technologies Austria AG, 9500 Villach (AT)
(72) Inventor: LEMETTINEN, Jori Anttoni, 9500 Villach (AT)
(74) Representative: JENSEN & SON

(57) **Abstract**

In an embodiment, a method of fabricating a Group III nitride layer on a substrate is provided, in which the method comprises placing a substrate comprising a growth surface in a chamber of an apparatus. The apparatus may be configured for MOPVE (Metal Organic Vapour Phase Epitaxy) processing. At a first substrate temperature, the MOPVE apparatus is supplied with a nitrogen-containing gas and no Group III element-containing gas for a first time period. After expiry of the first time period, the supply of the nitrogen-containing gas to the MOPVE apparatus is stopped. At a second substrate temperature that is less than the first substrate temperature, a Group III element-containing gas and no nitrogen-containing gas is supplied to the MOPVE apparatus for a second time period. After expiry of the second time period, the supply of the Group III element-containing gas to the MOPVE apparatus is stopped and the second substrate temperature is increased to a third substrate temperature that is greater than the second substrate temperature. The third substrate temperature is held for a third time period. After expiry of the third time period, the Group III element-containing gas and the N-containing gas is supplied to the MOPVE apparatus and a Group III nitride layer is formed on the growth surface of the substrate.

## Description

### BACKGROUND

To date, transistors used in power electronic applications have typically been fabricated with silicon (Si) semiconductor materials. Common transistor devices for power applications include Si CoolMOS^{®}, Si Power MOSFETs, and Si Insulated Gate Bipolar Transistors (IGBTs). Group III-N semiconductor devices, such as gallium nitride (GaN) devices, are now emerging as attractive candidates to carry large currents, support high voltages and to provide very low on-resistance and fast switching times.

Group III nitride devices are commonly fabricated by epitaxial growth of multiple Group III nitride layers on a foreign substrate, that is a substrate having a composition which is not a Group III nitride. Examples of foreign substrates are silicon, SiC and sapphire. US 2018/0158678 A1 describes a method for fabricating a Group III nitride device on a silicon substrate in order to avoid the formation of cracks in the Group III electron transfer layer of the Group III nitride device and warping of the silicon substrate.

It is desirable to further improve the quality of Group III nitride devices.

### SUMMARY

According to the invention, a method of fabricating a Group III nitride layer on a substrate is provided, in which the method comprises placing a substrate comprising a growth surface in a chamber of an apparatus. The apparatus may be configured for MOPVE (Metal Organic Vapour Phase Epitaxy) processing. At a first substrate temperature, the MOPVE apparatus is supplied with a nitrogen-containing gas and no Group III element-containing gas for a first time period. After expiry of the first time period, the supply of the nitrogen-containing gas to the MOPVE apparatus is stopped. At a second substrate temperature that is less than the first substrate temperature, a Group III element-containing gas and no nitrogen-containing gas is supplied to the MOPVE apparatus for a second time period. After expiry of the second time period, the supply of the Group III element-containing gas to the MOPVE apparatus is stopped and the second substrate temperature is increased to a third substrate temperature that is greater than the second substrate temperature. The third substrate temperature is held for a third time period. After expiry of the third time period, the Group III element-containing gas and the N-containing gas is supplied to the MOPVE apparatus and a Group III nitride layer is formed on the growth surface of the substrate.

The method is performed in this order. In this method, a nitridation process in which nitrogen gas and no Group III element-containing gas is supplied to the apparatus and substrate is followed by a conversion process in which a Group III element-containing gas and no nitrogen-containing gas is supplied to the apparatus and substrate followed by a bulk growth in which the Group III element-containing gas and the N-containing gas are supplied at the same time to the apparatus and substrate. Additionally, after the conversion process a desorption process is carried out by increasing the second substrate temperature to a third substrate temperature that is greater than the second substrate temperature and holding the third substrate temperature for a third period of time. This method results in the growth of a Group III nitride layer with fewer defects and improved crystallinity which in turn leads to an improvement in the crystallinity of any layers, e.g. Group III nitride layers, subsequently epitaxially grown upon it.

The substrate includes an upper or growth surface which is capable of supporting the epitaxial growth of one or more Group III nitride-base layers. In some embodiments, the substrate is a foreign substrate, i.e. is formed of a material other than Group III nitride materials, that includes the upper or growth which is capable of supporting the epitaxial growth of one or more Group III nitride-base layers. The foreign substrate may be formed of silicon and may be formed of monocrystalline silicon or an epitaxial silicon layer. In some embodiments, the foreign substrate is formed of SiC or sapphire.

In some embodiments, the Group III element is Al and the Group III nitride layer is AIN and the substrate may be formed of monocrystalline silicon or an epitaxial silicon layer and the growth surface may have a <111 > or <100> orientation.

The Group III nitride layer, e.g. the AIN layer on Si, may have a thickness of around 100 nm to 500 nm.

In some embodiments, the forming the Group III nitride layer on the growth surface comprises supplying the Group III element-containing gas and the N-containing gas to the MOPVE apparatus at a fourth substrate temperature that is less than the third substrate temperature but greater than the second substrate temperature and subsequently increasing the temperature to a fifth substrate temperature that is greater than the fourth substrate temperature. In some embodiments, the fifth substrate temperature is also greater than the first and the third substrate temperature.

In some embodiments, the fourth substrate temperature is held for a fourth time period and the fifth substrate temperature is held for a fifth time period.

In some embodiments, the method further comprises reducing the substrate temperature from the first substrate temperature to the second substrate temperature whilst supplying the nitrogen-containing gas and then stopping the supply of the nitrogen-containing gas to the MOPVE apparatus. The supply of the nitrogen-containing gas is continued during the cooling of the substrate from the first to the second substrate temperature and then the supply of the nitrogen-containing gas is stopped at the second substrate temperature.

In some embodiments, during the third period of time, a hydrogen-containing gas that is free of nitrogen and Group III elements is supplied to the MOPVE apparatus. The hydrogen-containing gas may be pure Hydrogen H₂ or a mixture of H₂ and a non-nitrogen-containing carrier gas such as Ar.

In some embodiments, the method further comprises, before supplying the nitrogen-containing gas to the MOPVE apparatus at the first substrate temperature, holding the first substrate temperature. In other words, the substrate is held at the first substrate temperature for an initial period of time and after expiry of this initial period of time the nitrogen-containing gas is supplied to the MOPVE apparatus at the first substrate temperature. During the heating of the substrate to the first substrate temperature and during the initial period of time at the first substrate temperature, a hydrogen-containing gas may be supplied to the MOPVE apparatus. This method may be used to clean the growth surface, for example to remove or desorb a native oxide on the growth surface in the case of a silicon substrate.

In some embodiments, the nitrogen containing gas comprises NH₃ (ammonia) and H₂ as a carrier gas and/or the Al-containing gas comprises TMAI (Trimethyl aluminium) and H₂ as a carrier gas.

In some embodiments, the substrate comprises a silicon wafer, for example a silicon wafer with a <111> or <100> growth surface. In other embodiments, the substrate comprises SiC or sapphire.

In some embodiments, the first, second, third, fourth and fifth substrate temperatures are in each case a set temperature of a heater controller that is connected to a wafer holder on which the substrate is placed. The actual temperature of the substrate may differ from the set temperature of the heater controller.

In some embodiments, the first, second, third, fourth and fifth substrate temperatures are in each case the measured temperature of the wafer holder or of the substrate. The temperature of the wafer holder or the substrate may be measured using IR sensor. In some embodiments, a combination of the wafer holder temperature and the IR-measured substrate surface temperature is used. For example, initially, the wafer holder temperature is used and then the IR is used to control and match the wafer surface temperature to a predetermined temperature.

In some embodiments, in the first time period a SiNₓ layer is formed at the growth surface of the substrate, in the second time period the SiNₓ layer is converted to a AIN layer, and in the third time period material is desorbed from the AIN layer. The material may be unwanted byproducts, i.e. material other than that of the desired Group III nitride layer. Examples of unwanted byproducts are SiNₓ or metallic aluminium.

In some embodiments, the AIN layer formed in the second time period further comprises Si remaining from the SiNₓ layer. Any Si may be removed from the AIN layer during the third time period.

In some embodiments:
the first substrate temperature lies within the range of 950°C and 1000°C and/or
the second substrate temperature lies within the range of 650°C and 750°C and/or
the third substrate temperature lies within the range of 950°C and 1000°C and/or
the fourth substrate temperature lies within the range of 875°C and 925°C and/or
the fifth substrate temperature lies within the range of 1025°C and 1075°C and/or
   the first time period lies within the range of 1 second and 1 min and/or
   the second time period lies within the range of 2 minutes and 5 minutes and/or
   the third time period lies within the range of 4 minutes and 8 minutes and/or
   the fourth time period lies within the range of 1 minute and 5 minutes and/or
   the fifth time period lies within the range of 25 minutes and 35 minutes.

The crystallinity of the Group III nitride layer grown using he method according to any one of the embodiments described herein may be determined using an omega rocking curve XRD measurement of a crystal direction and by measuring the FWHM (Full Width Half Maximum) of the omega rocking curve, whereby the higher the crystallinity, the smaller the FWHM of the peak.

In some embodiments, the substrate is a silicon <111> wafer and in an omega rocking curve XRD measurement of an AIN layer grown on the <111> silicon surface has a (002) peak having a FWHM of less than 1500 arcseconds, or less than 1200 arcsec.

In some embodiments, the method further comprises forming a multilayer Group III nitride-based structure for a transistor device on the Group III nitride layer.

In some embodiments, the forming the multilayer Group III nitride-based structure comprises forming a Group III nitride-based buffer layer on the Group III nitride layer, forming a Group III nitride-based channel layer on the Group III nitride-based buffer layer, forming a Group III nitride-based barrier layer the Group III nitride-based channel layer and forming a heterojunction therebetween. The Group III nitride channel layer and barrier layer have different compositions and different bandgaps. For example, the Group III nitride channel layer may be formed of GaN and the Group III nitride barrier layer may be formed of AlGaN.

The buffer layer may comprise two or more sublayers of differing composition. For example, the buffer layer may comprise a superlattice structure or a graded structure. The buffer layer may serve for compensating strain caused by lattice and thermal expansion mismatches between the substrate and overlying Group III nitride layers and may serve to reduce thread dislocations.

A typical transition or buffer structure for a silicon substrate includes an AIN starting layer, which may have a thickness of several 1 00nm, grown on the silicon substrate using the method of any one of the embodiments described herein followed by a AlₓGa₍₁₋ₓ₎N layer sequence, the thickness again being several 100nm's for each layer, whereby the Al content of about 50-75% is decreased down to 10-25% before the GaN layer or AlGaN back barrier, if present, is grown. Alternatively, a superlattice buffer can be used. Again, an AIN starting layer on the silicon substrate is used. Depending on the chosen superlattice, a sequence of AIN and AlₓGa₍₁₋ₓ₎N pairs is grown, where the thickness of the AIN layer and AlₓGa₍₁₋ₓ₎N is in the range of 2-25nm. Depending on the desired breakdown voltage the superlattice may include between 20 and 100 pairs. Alternatively, an AlₓGa₍₁₋ₓ₎N layer sequence as described above can be used in combination with the above mentioned superlattice.

The transistor device may be a High Electron Mobility Transistor device (HEMT) in which the channel is formed by piezoelectric and spontaneous polarisation at the heterojunction formed between the channel layer and barrier layer. The channel layer be formed of GaN and the barrier layer of AlGaN. Alternatively, the transistor device may be formed by doping to form the channel, e.g. be a MESFET/MOSFET. The transistor device may have a lateral or (quasi) vertical structure.

In some embodiments, the method further comprises forming a Group III nitride-based back barrier layer between the Group III nitride-based buffer layer and the Group III nitride-based channel layer and forming a heterojunction between the Group III nitride-based back barrier layer and the Group III nitride-based channel layer and the Group III nitride barrier layer is formed on channel layer. The back barrier layer has a different bandgap to the channel layer and may comprise AlGaN, for example, for a GaN channel layer. The composition of the AlGaN of the back barrier layer may differ from the composition of the AlGaN used for the barrier layer. The buffer layer may comprise a superlattice structure or a graded structure.

In some embodiments, the method further comprises forming a multilayer Group III nitride-based structure for a light emitting diode on the Group III nitride layer. The LEDs may comprise quantum confinement, e.g. quantum wells and/or wires and/or dots.

Those skilled in the art will recognize additional features and advantages upon reading the following detailed description, and upon viewing the accompanying drawings.

### BRIEF DESCRIPTION

The elements of the drawings are not necessarily to scale relative to each other. Like reference numerals designate corresponding similar parts. The features of the various illustrated embodiments can be combined unless they exclude each other. Exemplary embodiments are depicted in the drawings and are detailed in the description which follows.
Figure 1 illustrates a schematic view of apparatus for fabricating a Group III nitride layer on a substrate.
Figure 2A illustrates a schematic view of a process for fabricating a Group III nitride layer on a substrate.
Figure 2B illustrates schematic views of the substrate at different stages of the process depicted in figure 2A.
Figure 3 illustrates a Group III nitride device which is fabricated on the Group III nitride layer.
Figure 4 illustrates a schematic view of a Group III nitride LED device which is fabricated on the Group III nitride layer.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore runs in the thickness direction of the semiconductor material or semiconductor carrier.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

A depletion-mode device, such as a high-voltage depletion-mode transistor, has a negative threshold voltage which means that it can conduct current at zero gate voltage. These devices are normally on. An enhancement-mode device, such as a low-voltage enhancement-mode transistor, has a positive threshold voltage which means that it cannot conduct current at zero gate voltage and is normally off. An enhancement-mode device is not limited to low voltages and may also be a high-voltage device.

As used herein, the phrase "Group III-Nitride" refers to a compound semiconductor that includes nitrogen (N) and at least one Group III element, including aluminum (Al), gallium (Ga), indium (In), and boron (B), and including but not limited to any of its alloys, such as aluminum gallium nitride (AlₓGa₍₁₋ₓ₎N), indium gallium nitride (In_{y}Ga_{(1-y)}N), aluminum indium gallium nitride (AlₓIn_{y}Ga_{(1-x-y)}N), gallium arsenide phosphide nitride (GaAsₐP_{b}N_{(1-a-b)}), and aluminum indium gallium arsenide phosphide nitride (AlₓIn_{y}Ga_{(1-x-y)}AsₐP_{b}N_{(1-a-b)}), for example. Aluminum gallium nitride and AlGaN refers to an alloy described by the formula AlₓGa₍₁₋ₓ₎N, where 0 < x < 1.

Achieving the epitaxial growth of Group III nitrides such as GaN or AlGaN on foreign substrates such as silicon substrates is challenging due to lattice mismatch, thermal expansion mismatch and chemical incompatibility. One approach to improve chemical incompatibility is to use an AIN nucleation layer on a foreign substrate, such as silicon. Nevertheless, the atomic arrangement of Si and AIN is different and achieving nucleation with a good, clean interface is a challenge.

Precursor materials for synthesizing compound semiconductor consisting of two or more atoms, such as Al and N or Ga and N, are commonly provided in two separate steps for nucleation. This allows unwanted reaction pathways to be eliminated or mitigated and unwanted byproducts to be desorbed by thermal annealing after the nucleation steps. For example, two methods of epitaxially growing AIN on Si are nitridation and metallization nucleation of AIN. Nitridation is a process in which ammonia (nitrogen) is first processed. However, it is thought that a disordered AIN/SiN/Si-interface can be formed and, thus, reduced crystalline quality is achieved. Al-diffusion into Si may also occur. This diffusion dopes the Si substrate and may lead to electrical losses, for example in RF devices. Metallization is aluminum first process which is challenging to optimize but can lead to improvements in both crystal quality and reduced Al-diffusion.

In order to improve GaN quality on Si as well as other substrates, a method is provided which includes a binary nucleation process, in which AIN nuclei are created by converting SiN using Al precursor, TMAI.

In an exemplary embodiment of the method, the silicon substrate native oxide is first desorbed. Then, the substrate is nitridated using ammonia and the surface of the silicon substrate is either modified by adsorption of some nitrogen atoms or a thin (some nanometers or less) SiN layer is formed. In a subsequent process, the SiN layer is converted to AIN nuclei using an Al precursor, e.g. TMAI (trimethyl aluminium). However, some Si may nucleate on the surface and possibly some metallic Al may also be present. These unwanted byproducts are then desorbed by thermal annealing. After this thermal annealing, AIN layer growth is started by providing both precursors, ammonia and TMAI

AFM (Atomic Force Microscopy) and XRD (X-Ray Diffraction) analysis show that for AIN layers grown on <111> Si using the nitridation, metallization and binary nucleation process, decreased crystal disorder and better crystal quality and reduced surface roughness can be achieved.

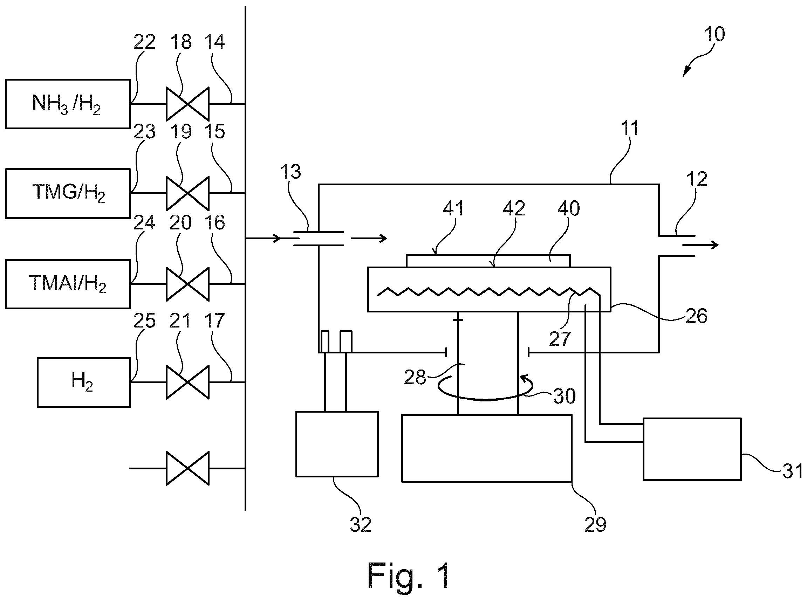

Figure 1 illustrates a schematic view of apparatus 10 for fabricating a Group III nitride layer on a substrate. The apparatus 10 comprises a processing chamber 11 which includes an outlet 12 which is coupled to a non-illustrated vacuum system for producing a vacuum within the chamber 11 and at least one inlet 13 which is coupled to a plurality of gas sources 22 to 25 by gas pipes 14 to 17. Each of the gas sources 22 to 25 is connectable to, and disconnectable from, a respective one of the gas pipes 14 to 17 by a respective valve 18 to 21. A substrate holder 26, also known as a wafer holder, is arranged within the chamber 11 and can be heated to different substrate temperatures by means of a heating means 27. The heating means 27 may be positioned within or adjacent to the substrate holder 26 and may have the form of a resistor, for example. The heating means 27 is controlled by a heater controller 31 which is situated external to the chamber 11. In some embodiments, the substrate holder 26 can be rotated and is mounted on an axis 28 which is rotated by a drive mechanism 29 about the axis 28 as is indicated by the arrow 30 in figure 1. The drive mechanism 29 is situated external to the chamber 11.

The apparatus 10 also includes a control unit 32 which is situated external to the chamber 11 and which is electrically coupled to non-illustrated sensor devices, for example vacuum sensors, the valves 18 to 21, the vacuum pumping system and non-illustrated entry/exit system for inserting and removing a substrate from the chamber 11 among other components. In this embodiment, the apparatus 10 is a MOPVE (Metal Organic Vapour Phase Epitaxy) apparatus.

In order to fabricate a Group III nitride layer on a substrate 40 using the apparatus 10, a substrate 40 is positioned within the chamber 11 on the substrate holder 26 such that the substrate 40 can be heated by means of the heater 27 and its controller 31. Precursors of nitrogen and one or more Group III elements are supplied to the chamber 11 while this substrate 40 is at an increased temperature by opening an appropriate one of the valves 18 to 21 so that nitrogen and/or a Group III element is deposited ono the substrate 40 to grow a film of a Group III nitride.

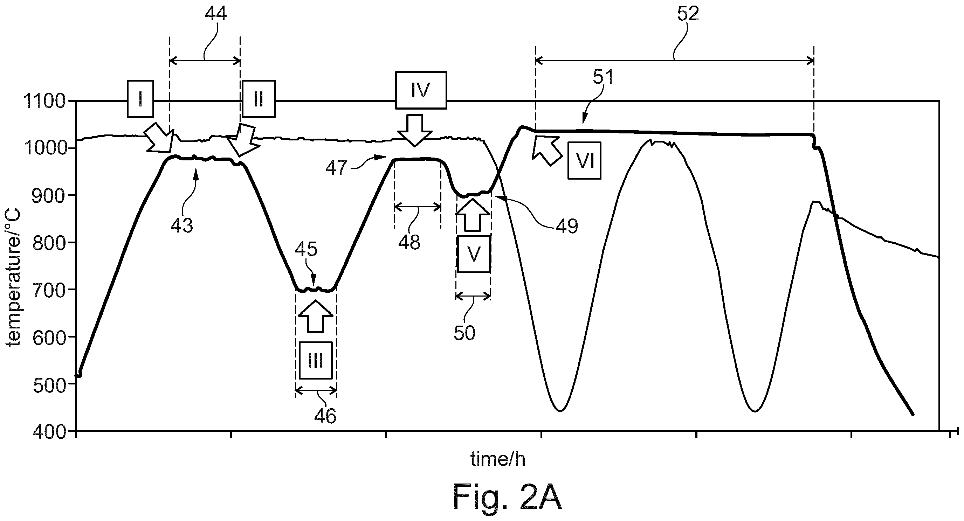

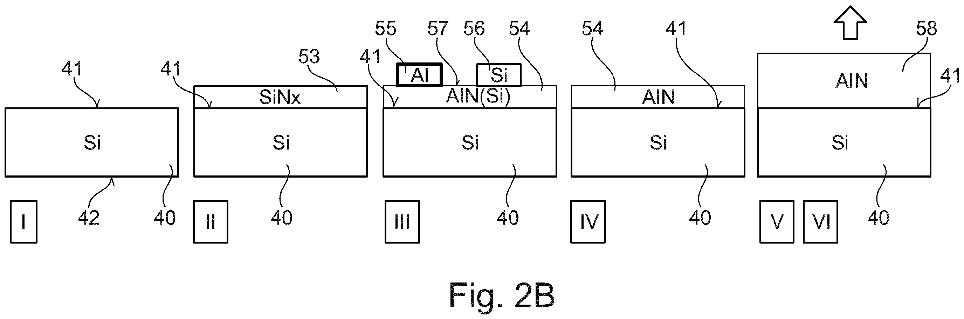

Figure 2A illustrates a schematic view of process for fabricating a Group III nitride layer on a substrate and shows the process as a graph of temperature of the substrate against time. Figure 2B illustrates schematic views of the substrate and the growth of the Group III nitride layer on the substrate at different stages of the process of figure 2A. This process may be carried out using the apparatus 10 illustrated in figure 1.

In some embodiments, the substrate 40 is a monocrystalline wafer which has a growth surface 41 which is capable of supporting the epitaxial growth of one or more Group III nitride layers and a rear surface 42 which opposes the growth surface 41. The substrate may be a monocrystalline silicon wafer and the growth surface 41 may have a <111> orientation. The rear surface 42 is positioned on the substrate holder 26 such that the substrate 40 can be heated to predetermined temperatures by means of the heater 27 and control system 31.

Referring to figure 2A, the substrate 40 is heated up from room temperature to a first substrate temperature 43. At the first substrate temperature 43, the apparatus 10 is supplied with a nitrogen-containing gas and no Group III element containing gas for first time period 44. For example, the valve 18 may be opened to allow ammonia containing gas 22 to be supplied through the pipe 14 via the inlet 13 to the chamber 11. The pipe 14 may be connected to a pure ammonia (NH₃) source 22 or source 22 of ammonia (NH₃) with a carrier gas, such as hydrogen H₂. In some embodiments, the carrier gas is supplied to the chamber 11 by a separate valve and gas supply pipe, such as the valve 21 and gas supply pipe 17 shown in figure 1. The valves 19 and 20 which are coupled to a gallium source 23, TMG (trimethyl gallium), and an aluminium source 24, TMAI (trimethyl aluminium) remain closed. For example, the first substrate temperature 43 may lie within the range of 950°C and 1000°C and the first time period 44 may lie within the range of 1 second and 1 min.

In some embodiments, after the substrate 40 has been heated to the first substrate temperature 43, the first substrate temperature 43 is held for an initial period of time before supplying the nitrogen-containing gas to the apparatus 10 at the first substrate temperature. This embodiment may be used to clean the substrate 40 by desorbing unwanted components that may be present, for example a native oxide layer for a silicon wafer, on the growth surface 41.

After expiry of the first time period 44, the supply of the nitrogen-containing gas to the chamber 11 is stopped, for example by closing the valve 18 and disconnecting the ammonia source 22 from the inlet 13. The wafer 40 cools down to a second substrate temperature 45, which is less than the first substrate temperature 43. At the second substrate temperature 45, a Group III element containing gas and no nitrogen-containing gas is supplied to the chamber 11 for a second time period 46. For example, the valve 20 may be opened to allow the aluminium-containing gas source 24 to be coupled to the supply pipe 16 and the inlet 13 and to be supplied to the chamber 11. The valves 18, 19 and 20 remain closed. The aluminium-containing gas source 24 may include a carrier gas such as hydrogen. In some embodiments, the carrier gas is supplied to the chamber 11 by a separate valve and gas supply pipe, such as the valve 21 and gas supply pipe 17 shown in figure 1. The second substrate temperature 45 may lie within the range of 650°C and 750°C and is less than the first substrate temperature 43 and the second time period 46 may lie within the range of 2 minutes and 5 minutes

In some embodiments, the temperature of the substrate 40 is lowered from the first substrate temperature 43 to the second substrate temperature 45 whilst supplying the nitrogen-containing gas and then the supply of the nitrogen-containing gas to the chamber 11 of the apparatus is 10 stopped upon reaching the second substrate temperature 45.

After expiry of the second time period 46, the supply of the Group III element containing gas, that is the aluminium-containing gas 24, to the chamber 11 is stopped by closing the valve 20. The temperature of the substrate 40 is increased to a third substrate temperature 47 which is greater than the second substrate temperature 45 and the substrate 40 is held at the third substrate temperature 47 for a third time period 48. During the third time period 48 no Group III element containing gas and no nitrogen-containing gas is supplied to the chamber 11. The third substrate temperature 47 may lie within the range of 950°C and 1000°C and is greater than the second substrate temperature 45 and the third time period 48 within the range of 4 minutes and 8 minutes

In some embodiments, during the third period of time 48, a hydrogen-containing gas that is free of nitrogen and Group III elements is supplied to the chamber 11 of the apparatus 10. For example, the valve 21 can be opened to allow the supply of the H₂ gas 25 to the chamber 11 whilst the other valves 18, 19, 20 remain closed. The third substrate temperature 47 and the third period of time 48 may be used to desorb unwanted components from the substrate 40 or layer grown on the substrate 40.

After expiry of the third time period 48, the Group III nitride element containing gas and the nitrogen-containing gas are supplied to the chamber 11 at the same time and a Group III nitride layer 58 including the Group III element and nitrogen is formed on the growth surface 41 of the wafer 40. For example, the aluminium-containing source 24 and the nitrogen-containing source 22 may be supplied at the same time to the chamber 11 by opening the valves 18 and 20 and an AIN layer 58 is grown on the growth surface 41.

The Group III nitride layer 58 may be formed on the growth surface 41 after expiry of the third time period 48 by cooling the substrate 40 to a fourth substrate temperature 49, which is less than the third substrate temperature 47 and less than the first substrate temperature 43 but greater than the second substrate temperature 45. At the fourth substrate temperature 49, both the Group III element containing gas and the nitrogen-containing gas are supplied to the chamber 11 for a fourth time period 50. Upon expiry of the fourth time period 50, the temperature of the substrate 40 is increased to a fifth substrate temperature 59 which is greater than the fourth substrate temperature 49. The fifth substrate temperature 51 is held for a fifth time period 52 and after expiry the fifth time period 52, the substrate 40 is allowed to cool. The fifth time period 52 may be selected depending on the desired thickness of the Group III nitride layer 58 formed on the growth surface 41. The fifth substrate temperature 51 may also be greater than the first substrate temperature 43.

The fourth substrate temperature 49 may lie within the range of 875°C and 925°C and be less than the third substrate temperature 47, less than the first substrate temperature 43 but greater than the second substrate temperature 45. The fourth time period 50 may lie within the range of 1 minute and 5 minutes. The fifth substrate temperature 51 may lie within the range of 1025°C and 1075°C and be greater than the fourth substrate temperature 49 and greater than the first substrate temperature 43. The fifth time period 52 may lie within the range of 25 minutes and 35 minutes.

The first, second, third, fourth and fifth substrate temperatures 43, 45, 47, 49, 51 may be in each case a set temperature of the heater controller 31 that is connected to the wafer holder 26 on which the substrate 40 is placed. The actual temperature of the substrate 40 may differ from the set temperature of the heater controller 31.

Figure 2B illustrates schematic cross-sectional views of the substrate 40 at six stages during the process described with reference to figure 2A. These stages are indicated in figures 2A and 2B with roman numerals I, II, III, IV, V and VI.

At stage I, the substrate 40 is depicted at the beginning of the first time period 44 and figure 2B illustrates the substrate 40, in this example a <111> Si wafer, with a clean growth surface 41. Stage II depicts the substrate 40at the end of the first time period 44 during which a nitrogen-containing gas only has been supplied to the chamber 11. At the expiry of the first time period 44, a silicon nitride layer 53 has been formed on the growth surface 41.

After the expiry of the first time period 44, the supply of the nitrogen-containing gas is stopped and the first substrate temperature 44 is reduced to the lower second substrate temperature 45 and the Group III element containing gas but no nitrogen-containing gas is supplied, which is represented by stage III. In the second time period 46, the silicon nitride layer 53 is converted in to an aluminium nitride layer 54 as shown by the depiction of the substrate 40 at the end of the second time period 46 as depicted as stage III in figure 2B. The initial as grown aluminium nitride layer 54 may include some Si.

At stage III, the aluminium nitride layer 54 may include regions 55 comprising aluminium and/ or regions 56 comprising silicon which are arranged on the surface 57 of the aluminium nitride layer 54. These additional regions 55, 56 are removed or desorbed using the increased third substrate temperature 47 which is held for the third time period 48. The Group III element-containing gas is stopped for stage IV. After the third time period 48 the substrate 40 has a clean surface formed of AIN as depicted in stage IV shown in figure 2B.

Subsequent to stage IV, the thickness of the remainder of the aluminium nitride layer 54 is increased to form the aluminium nitride layer 58 on the growth surface 41 of the substrate 40 as shown in stages V and VI of Figure 2B. In some embodiments, such as that illustrated in figure 2A, the subsequent growth of the AIN layer 58 may take place at two or more different substrate temperatures with stage V depicting the aluminium nitride layer 58 during the fourth time period 50 at the lower fourth substrate temperature 49 and stage VI depicting the continued growth of the aluminium nitride layer 58 towards the beginning of the fifth time period 52 at the higher fifth substrate temperature 51.

With the process illustrated in figure 2A, a Group III nitride layer, for example AIN layer 58, can be grown on a foreign substrate 40 with a reduced surface roughness and with reduced crystalline defects and higher crystallinity. For a silicon <111 > wafer 40, the AIN layer 58 may have a (002) peak having a FWHM of less than 1200 arcseconds in an omega rocking curve XRD measurement. This small XRD peak width is indicative of less disorder in the crystal structure and, therefore, of layer with a higher crystalline quality. This provides a good surface onto which further Group III nitride layers can be epitaxially grown with increased quality. The aluminium nitride layer 58 may be used as a nucleation or transition layer onto which one or more further Group III nitride layers for forming a semiconductor device can be fabricated.

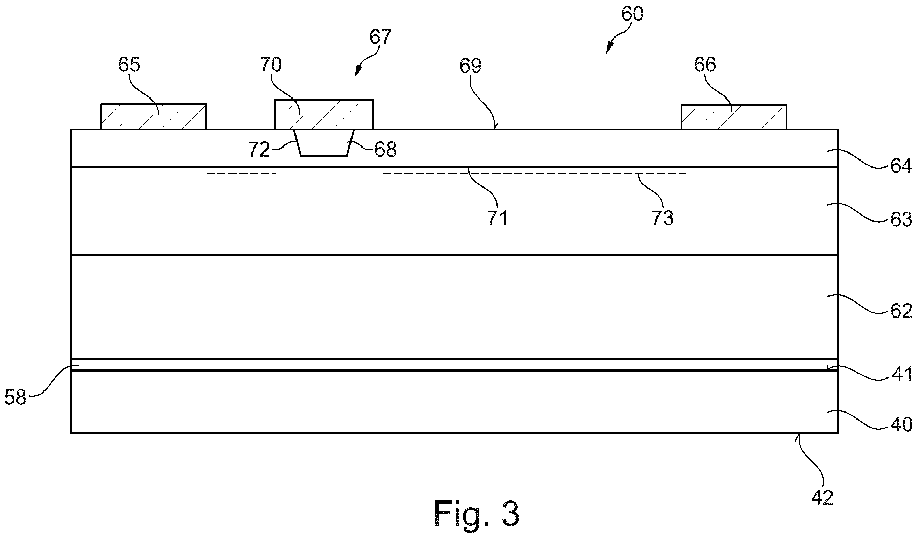

Figure 3 illustrates a Group III nitride transistor device 60 which may be subsequently fabricated on the aluminium nitride layer 58 formed on the growth surface 41 of the substrate 40. The Group III nitride transistor device 60 may be, or portions of the Group III nitride transistor device 60, may be fabricated in the same apparatus as the aluminium nitride layer 58 with or without breaking vacuum or the substrate 40 may be moved to a further apparatus for the deposition of one or more layers, for example the metallization structure.

A Group III nitride buffer structure 62 is epitaxially grown on the aluminium nitride layer 58, a channel layer 63 is formed on the buffer layer 62 and a barrier layer 64 is formed on the channel layer 63. The channel layer 63 may be formed of gallium nitride and the barrier layer 64 may be formed of aluminium gallium nitride. A two-dimensional charge gas, e.g. a two-dimensional electron gas (2DEG), is formed at the heterojunction 71 formed between the channel layer 63 and the barrier layer 64. The two-dimensional charge gas is indicated schematically in figure 3 by the dashed line 73.

A source electrode 65, a drain electrode 66 and a gate 67 are then formed on the barrier layer 60. The source electrode 65 and drain electrode 66 are laterally spaced from one another on the upper surface 69 of the barrier layer 64 with the gate 64 being arranged laterally between the source electrode 65 and the drain electrode 66. The source electrode 65 and drain electrode 66 may form an ohmic connection to the two-dimensional charge gas 73. The Group III nitride transistor device 60 may be a HEMT.

The gate 67 may include a p-doped Group III nitride layer 68 and a gate metal layer 70 arranged on the p-doped Group III nitride layer 68. The p-doped Group III nitride layer 68 may be positioned on the upper surface 69 of the barrier layer 64, whereby the barrier layer 64 has a substantially uniform thickness from the source electrode 65 to the drain 55 electrode. In some embodiments, the p-doped Group III nitride layer 68 is positioned in a recess 72 formed in the upper surface 69 of the barrier layer 64 such that the barrier layer 64 has a reduced thickness under the gate 67 compared to regions laterally adjacent the gate 67. In some embodiments, the gate 67 comprises a gate metal layer 70 arranged in the recess 72. These arrangements may be used to provide an enhancement mode Group III nitride transistor device 60, which is normally off.

In other embodiments, the gate 67 may be formed of the gate metal 70 only which is positioned on the upper surface 69 of the barrier layer 64 and the barrier layer 64 has a substantially uniform thickness from the source electrode 65 to the drain 55 electrode. In these embodiments, the Group III nitride device may be a depletion mode device that is normally on.

Other types of devices may be formed on the aluminium nitride layer 58 including other types of Group III nitride transistor devices, e.g. with a doped channel, and Group III nitride-based devices such as LEDs (Light Emitting diode).

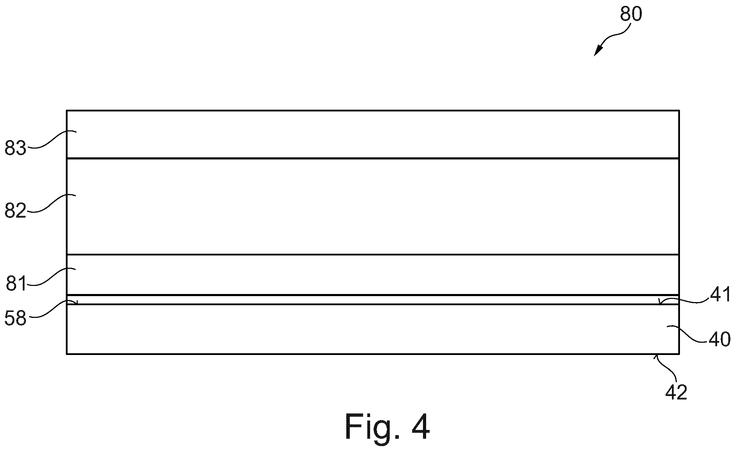

Figure 4 illustrates a schematic diagram of a LED 80 formed on the substrate 40 including the AIN layer 58 formed on the growth surface 41. The LED comprises a n-type Group III nitride layer 81 formed on the AIN layer 58, an active layer 82 formed on the n-type Group III nitride layer 81 and a p-type Group III nitride layer 83 formed on the active layer 82 so that the active layer 82 is arranged in the stack between the n-type and p-type Group III nitride layers 81, 83.

In order to improve the quality of epitaxial Group III nitride layers on Si as well as other substrates, a method is provided which includes a binary nucleation process, in which Group III nitride nuclei are created by converting a nitrogen containing surface layer using Group III precursor, e.g. TMAI, to fabricate a Group III nitride nucleation layer on the substrate. In an exemplary embodiment of the method, the Si substrate native oxide is first desorbed. Then, the substrate is nitridated using ammonia and the surface of the substrate is either modified by adsorption of some nitrogen atoms or a thin (some nanometers or less) SiN layer is formed. In a subsequent process, the SiN layer is converted to AIN nuclei using an Al precursor, e.g. TMAI. However, some Si may nucleate on the surface and possibly some metallic Al may also be present. These unwanted byproducts are then desorbed by thermal annealing. After this thermal annealing, AIN layer growth is started by providing both precursors, ammonia and TMAI.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise. It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. Method of fabricating a Group III nitride layer on a substrate, the method comprising:
placing a substrate comprising a growth surface in a MOPVE apparatus,
at a first substrate temperature, supplying the MOPVE apparatus with a nitrogen-containing gas and no Group III element-containing gas for a first time period;
after expiry of the first time period stopping the supply of the nitrogen-containing gas to the MOPVE apparatus;
at a second substrate temperature that is less than the first substrate temperature, supplying a Group III element-containing gas and no nitrogen-containing gas to the MOPVE apparatus for a second time period;
after expiry of the second time period stopping the supply of the Group III element-containing gas to the MOPVE apparatus;
increasing the second substrate temperature to a third substrate temperature that is greater than the second substrate temperature and holding the third substrate temperature for a third time period;
after expiry of the third time period supplying the Group III element-containing gas and the N-containing gas to the MOPVE apparatus and forming a Group III nitride layer on the growth surface.

2. A method according to claim 2, wherein the Group III element is Al and the Group III nitride layer is AIN.

3. A method according to claim 1 or claim 2, wherein the forming the Group III nitride layer on the growth surface comprises:
supplying the Group III element-containing gas and the N-containing gas to the MOPVE apparatus at a fourth substrate temperature that is less than the third substrate temperature but greater than the second substrate temperature and increasing the temperature to a fifth substrate temperature than is greater than the fourth substrate temperature.

4. A method according to claim 3, wherein the fourth substrate temperature is held for a fourth time period and the fifth substrate temperature is held for a fifth time period.

5. A method according to any one of claims 1 to 4, further comprising:
lowering the substrate temperature from the first substrate temperature to the second substrate temperature whilst supplying the nitrogen-containing gas and then stopping the supply of the nitrogen-containing gas to the MOPVE apparatus.

6. A method according to any one of claims 1 to 5, wherein during the third period of time, a hydrogen-containing gas that is free of nitrogen and Group III elements is supplied to the MOPVE apparatus.

7. A method according to any one of claims 1 to 6, further comprising, before supplying the nitrogen-containing gas to the MOPVE apparatus at the first substrate temperature, holding the first substrate temperature.

8. A method according to any one of claims 1 to 7, wherein the nitrogen containing gas comprises NH₃ and H₂ as a carrier gas and/or the Al-containing gas comprises TMAI and H₂ as a carrier gas and/or the substrate comprises a silicon wafer or SiC or sapphire.

9. A method according to any one of claims 1 to 8, wherein the first, second, third, fourth and fifth substrate temperatures are in each case a set temperature of a heater controller that is connected to a wafer holder on which the substrate is placed.

10. A method according to any one of claims 1 to 9, wherein
in the first time period a SiNₓ layer is formed at the growth surface of the substrate;
in the second time period the SiNₓ layer is converted to a AIN layer, and
in the third time period material is desorbed from the AIN layer.

11. A method according to any one of claims 1 to 10, wherein
the first substrate temperature lies within the range of 950°C and 1000°C and/or
the second substrate temperature lies within the range of 650°C and 750°C and/or
the third substrate temperature lies within the range of 950°C and 1000°C and/or
the fourth substrate temperature lies within the range of 875°C and 925°C and/or
the fifth substrate temperature lies within the range of 1025°C and 1075°C and/or
the first time period lies within the range of 1 second and 1 min and/or
the second time period lies within the range of 2 minutes and 5 minutes and/or
the third time period lies within the range of 4 minutes and 8 minutes and/or
the fourth time period lies within the range of 1 minute and 5 minutes and/or
the fifth time period lies within the range of 25 minutes and 35 minutes.

12. A method according to claim 10 or claim 11, wherein the substrate is a silicon <111 > wafer and in an omega rocking curve XRD measurement of the AIN layer has a (002) peak having a FWHM of less than 1200 arcseconds.

13. A method according to any one of claims 1 to 12, further comprising forming a multilayer Group III nitride-based structure for a transistor device on the Group III nitride layer.

14. A method according to claim 13, wherein the forming the multilayer Group III nitride-based structure comprises:
forming a Group III nitride-based buffer layer on the Group III nitride layer;
forming a Group III nitride-based channel layer on the Group III nitride-based buffer layer;
forming a Group III nitride-based barrier layer the Group III nitride-based channel layer and forming a heterojunction therebetween.

15. A method according to any one of claims 1 to 12, further comprising forming a multilayer Group III nitride-based structure for a light emitting diode on the Group III nitride layer.
